(19)

Europäisches
Patentamt
European
Patent Office
Office européen
des brevets

(11) **EP 4 030 466 A1**

(12) **EUROPEAN PATENT APPLICATION**
published in accordance with Art. 153(4) EPC

(43) Date of publication:
**20.07.2022 Bulletin 2022/29**

(21) Application number: **20880184.5**

(22) Date of filing: **05.10.2020**

(51) International Patent Classification (IPC):
**H01L 21/304** (2006.01)    **B29C 70/06** (2006.01)

(52) Cooperative Patent Classification (CPC):
**B29C 70/06; H01L 21/304**

(86) International application number:
**PCT/JP2020/037733**

(87) International publication number:
**WO 2021/079724 (29.04.2021 Gazette 2021/17)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **23.10.2019 JP 2019192937**

(71) Applicant: **Daikin Industries, Ltd.
Osaka-shi, Osaka 530-8323 (JP)**

(72) Inventors:
• **MURAKAMI, Shinji
Osaka-Shi, Osaka 530-8323 (JP)**
• **YUKAWA, Hirokazu
Osaka-Shi, Osaka 530-8323 (JP)**
• **HAGI, Keisuke
Osaka-Shi, Osaka 530-8323 (JP)**
• **MASUI, Toshiaki
Osaka-Shi, Osaka 530-8323 (JP)**

(74) Representative: **Hoffmann Eitle
Patent- und Rechtsanwälte PartmbB
Arabellastraße 30
81925 München (DE)**

(54) **MEMBER FOR SEMICONDUCTOR CLEANING APPARATUS**

(57)    Provided are members for semiconductor cleaning apparatuses, the members being resistant to thermal deformation and less likely to cause metal release. The disclosure relates to a member for a semiconductor cleaning apparatus, including prepreg containing a carbon fiber and a tetrafluoroethylene/perfluoro(alkyl vinyl ether) copolymer which are thermally fused with each other.

EP 4 030 466 A1

**Description**

TECHNICAL FIELD

The disclosure relates to members for semiconductor cleaning apparatuses.

BACKGROUND ART

In semiconductor manufacturing, semiconductor wafers are cleaned to remove contaminants, such as particles, from the wafers. Known apparatuses for such cleaning include a single-wafer cleaning apparatus and a batch cleaning apparatus.

Patent Literature 1 discloses a single-wafer cleaning apparatus including a turntable that supports and rotates a wafer and first and second jet nozzles each having a specific structure.

CITATION LIST

- Patent Literature

[0004]  - Patent Literature 1: JP 2001-358109 A

SUMMARY OF INVENTION

- Technical Problem

The disclosure aims to provide members for semiconductor cleaning apparatuses, the members being resistant to thermal deformation and less likely to cause metal release.

- Solution to Problem

The disclosure relates to a member for a semiconductor cleaning apparatus, including prepreg containing a carbon fiber and a tetrafluoroethylene/perfluoro(alkyl vinyl ether) copolymer which are thermally fused with each other.

Preferably, two or more sheets of the prepreg are stacked and combined by heat compression.

Preferably, the prepreg includes a thermally fused article of a sheet of the carbon fiber and a film of the tetrafluoroethylene/perfluoro(alkyl vinyl ether) copolymer.

The disclosure also relates to a member for a semiconductor cleaning apparatus, including a carbon fiber having an average fiber length of 0.5 mm or greater and a tetrafluoroethylene/perfluoro(alkyl vinyl ether) copolymer.

Preferably, the carbon fiber represents 5 to 70% by volume of a total amount of the carbon fiber and the tetrafluoroethylene/perfluoro(alkyl vinyl ether) copolymer.

Preferably, the carbon fiber is opened.

Preferably, the member is to be brought into contact with at least one selected from the group consisting of sulfuric acid, hydrogen peroxide, hydrofluoric acid, hydrochloric acid, nitric acid, and phosphoric acid.

Preferably, the member is to be brought into contact with a cleaning chemical at a temperature of 100°C or higher.

Preferably, the member causes an Al release of 1.47 ng/cm$^2$ or less after 24-hour immersion in 3.6% by mass hydrochloric acid.

Preferably, the member causes an Al release of 1.47 ng/cm$^2$ or less after 168-hour immersion in 3.6% by mass hydrochloric acid.

Preferably, the member causes a Ca release of 14.7 ng/cm$^2$ or less after 24-hour immersion in 3.6% by mass hydrochloric acid.

Preferably, the member causes a Ca release of 14.7 ng/cm$^2$ or less after 168-hour immersion in 3.6% by mass hydrochloric acid.

Preferably, the member exhibits a thermal deformation of 1.0% or lower after 60-minute heating at 220°C.

Preferably, the member exhibits a thermal deformation of 1.0% or lower after 60-minute heating at 260°C.

- Advantageous Effects of Invention

The disclosure can provide members for semiconductor cleaning apparatuses, the members being resistant to thermal deformation and less likely to cause metal release.

BRIEF DESCRIPTION OF DRAWINGS

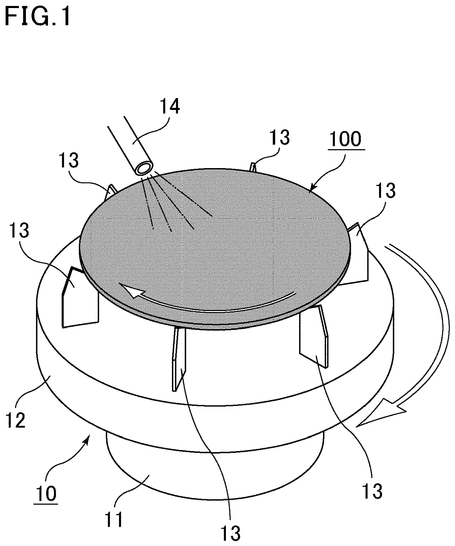

Fig. 1 is a view schematically showing an example of a semiconductor cleaning apparatus to which members of the disclosure are applicable.

DESCRIPTION OF EMBODIMENTS

The following specifically describes the disclosure.

The disclosure relates to a member for a semiconductor cleaning apparatus (hereinafter, also referred to as a first member), including prepreg containing a carbon fiber and a tetrafluoroethylene/perfluoro(alkyl vinyl ether) copolymer which are thermally fused with each other.

The first member is resistant to thermal deformation and is less likely to cause metal release.

Also, the first member has excellent strength, excellent conductivity (charge elimination property), and excellent chemical resistance.

The prepreg of the first member contains a carbon fiber and PFA which are thermally fused with each other. Such prepreg allows the member to be resistant to thermal deformation and to have excellent strength and conductivity. Also, the prepreg can prevent or reduce metal release caused by penetration of a cleaning chemical into the member.

Preferably, in the prepreg, the PFA permeates the carbon fiber. This can reduce the voids in the member. Thus, the thermal deformation of the member can be further prevented or reduced, and the metal release caused by penetration of a cleaning chemical into the member can be further prevented or reduced.

The carbon fiber in the prepreg preferably has an average fiber length of 0.5 mm or greater, more preferably 1 mm or greater, still more preferably 2 mm or greater, further more preferably 5 mm or greater, and particularly preferably 10 mm or greater. The upper limit of the average fiber length may be, but not limited to, the maximum length of the member.

When focused on the strength, the carbon fiber preferably has a greater average fiber length (in the form of continuous fiber). When the member is finished by cutting, the carbon fiber preferably has a smaller average fiber length in order to prevent or reduce the fluff.

The average fiber length may be the average fiber length of the carbon monofilaments constituting the carbon fiber.

The average fiber length may be measured with a microscope.

The carbon fiber preferably has an average diameter of 0.5 $\mu$m or greater, more preferably 3 $\mu$m or greater, still more preferably 5 $\mu$m or greater, and preferably 50 $\mu$m or smaller, more preferably 30 $\mu$m or smaller, still more preferably 15 $\mu$m or smaller.

The average diameter may be the average diameter of the carbon monofilaments constituting the carbon fiber.

The average diameter may be measured with a microscope.

The carbon fiber may be surface-treated. The carbon fiber may be treated with a treatment agent or a sizing agent.

Non-limiting examples of the form of the carbon fiber include a unidirectional carbon fiber sheet including carbon monofilaments paralleled in one direction, a laminate of two or more unidirectional carbon fiber sheets stacked at different angles, a sheet in which the carbon monofilaments are two dimensionally randomly oriented, fabric such as woven fabric, knitted fabric, or non-woven fabric formed from the carbon monofilaments, and a strand such as a braid. In the case of a laminate, multiple layers may be stacked in different orientations, alternately stacked, or symmetrically placed in the thickness direction.

The carbon fiber is preferably in the form of a sheet, more preferably in the form of a unidirectional carbon fiber sheet including carbon fibers paralleled in one direction, woven fabric, or non-woven fabric, still more preferably in the form of a unidirectional carbon fiber sheet.

Examples of the carbon fiber include polyacrylonitrile-based, pitch-based, rayon-based, cellulose-based, lignin-based, phenol-based, and vapor-deposited carbon fibers. Preferred are polyacrylonitrile-based, pitch-based, and rayon-based carbon fibers, with a polyacrylonitrile-based carbon fiber being more preferred.

Preferably, the carbon fiber is opened. Thereby, the PFA further highly permeates the carbon fiber, and thus, the thermal deformation and metal release can be further prevented or reduced.

The fiber may be opened by any method such as a method of passing the fiber alternately along projected and depressed rolls, a method of using a drum roll, a method of applying tension fluctuation to the vibration in the axial direction, a method of varying the tension of the carbon fiber bundle using vertically reciprocating two frictional bodies, or a method of blowing air to the carbon fiber bundle. Alternatively, the fiber may be opened by the methods described in JP 3064019 B and JP 3146200 B.

The carbon fiber has a weight per unit area of preferably 100 g/m$^2$ or less, more preferably 80 g/m$^2$ or less, still more preferably 50 g/m$^2$ or less, further more preferably 30 g/m$^2$ or less, particularly preferably 20 g/m$^2$ or less, and preferably 10 g/m$^2$ or more. The PFA more easily permeates a carbon fiber with a lower weight per unit area.

The PFA contains a polymerized unit based on tetrafluoroethylene (TFE) (TFE unit) and a polymerized unit based on perfluoro(alkyl vinyl ether) (PAVE) (PAVE unit).

Non-limiting examples of the PAVE include those represented by the following formula (1):

$$CF_2=CF-ORf^1 \qquad (1)$$

wherein $Rf^1$ is a C1-C10 perfluoroalkyl group, preferably a C1-C5 perfluoroalkyl group. Particularly preferred are perfluoro(methyl vinyl ether) (PMVE), perfluoro(ethyl vinyl ether) (PEVE), and perfluoro(propyl vinyl ether) (PPVE).

The PFA is preferably, but not limited to, a copolymer in which the proportion of the TFE unit to the total of the TFE unit and the PAVE unit is 70 mol% or more and less than 99.5 mol%, more preferably a copolymer in which the proportion of the TFE unit to the total of the TFE unit and the PAVE unit is 70 mol% or more and 98.9 mol% or less, still more preferably a copolymer in which the proportion of the TFE unit to the total of the TFE unit and the PAVE unit is 80 mol% or more and 98.7 mol% or less. The PFA may be a copolymer consisting of TFE and PAVE units, preferably a copolymer in which a monomer unit derived from a monomer copolymerizable with TFE and PAVE is 0.1 to 10 mol% of all monomer units and the sum of the TFE unit and the PAVE unit is 90 to 99.9 mol% of all monomer units. Examples of the monomer copolymerizable with TFE and PAVE include hexafluoropropylene (HFP), a vinyl monomer represented by $CZ^1Z^2=CZ^3(CF_2)nZ^4$ (wherein $Z^1$, $Z^2$, and $Z^3$ are the same as or different from each other and are each a hydrogen atom or a fluorine atom; $Z^4$ is a hydrogen atom, a fluorine atom, or a chlorine atom; and n is an integer of 2 to 10) and an alkylperfluorovinyl ether derivative represented by $CF_2=CF-OCH_2Rf^{11}$ (wherein $Rf^{11}$ is a C1-C5 perfluoroalkyl group).

The amount of each monomer constituting the PFA herein may be calculated by appropriately combining NMR, FT-IR, elemental analysis, and fluorescent X-ray analysis depending on the type of the monomer.

The PFA preferably has a melting point of 180°C to 340°C, more preferably 230°C to 330°C, still more preferably 280°C to 320°C. The melting point is the temperature corresponding to the maximum value on a heat-of-fusion curve obtained by increasing the temperature at a rate of 10°C/min using a differential scanning calorimeter (DSC).

The PFA preferably has a melt flow rate (MFR) of 0.1 to 100 g/10 min, more preferably 0.5 to 90 g/10 min, still more preferably 1.0 to 85 g/10 min.

The MFR herein is a value determined at a temperature of 372°C and a load of 5 kg in conformity with ASTM D1238.

The carbon fiber in the first member preferably represents 5 to 70% by volume of a total amount of the carbon fiber and the PFA. The carbon fiber more preferably represents 10% by volume or more, still more preferably 15% by volume or more, and more preferably represents 60% by volume or less, still more preferably represents 50% by volume or less.

The member containing the carbon fiber in an amount within the above range is further resistant to thermal deformation and has further enhanced conductivity.

The prepreg can be produced by thermally fusing the carbon fiber and the PFA. The carbon fiber and the PFA may be fused by any method. For example, the carbon fiber and the PFA being in contact with each other are heated to a temperature equal to or higher than the melting point of the PFA. When brought into contact with the carbon fiber, the PFA may be in any form and may be in the form of powder, film, or solvent dispersion. In view of productivity and quality stability, the PFA is preferably in the form of a film.

Preferably, the prepreg includes a thermally fused article of a sheet of the carbon fiber and a film of the PFA.

The prepreg may be in the form of a sheet.

The prepreg may be cut into small pieces in the form of chopped materials. The chopped materials are two dimensionally randomly oriented to form a laminate, in which the carbon fiber can be quasi-isotropically oriented. Thereby, a member having a smaller difference in strength depending on the direction can be obtained. The chopped materials can also be easily formed into a complicated shape.

Also, the prepreg may be a quasi-isotropic reinforced sheet material produced from a chopped semi-prepreg sheet material unimpregnated with resin as disclosed in JP 2016-27956 A.

The first member may contain one or more sheets of the prepreg, and preferably contains two or more sheets of the prepreg.

The upper limit of the number of sheets is not limited and may be determined depending on a thickness or the like required for the member.

When the first member contains two or more sheets of the prepreg, the orientation of the carbon fiber may be the same or different between the sheets of the prepreg. When the first member contains two or more sheets of the prepreg, the two or more sheets of the prepreg are preferably stacked and combined by heat compression. The term "combined" means that the sheets of the prepreg are thermally fused with each other to form one member. The interface between the sheets of the prepreg thermally fused with each other is not necessarily clear.

The first member can be produced, for example, as follows. The prepreg is molded by pressurizing while heating to a temperature equal to or higher than the melting point of the PFA, and is cooled to a temperature equal to or lower than the crystallization temperature of the PFA with the pressure being applied. When two or more sheets of the prepreg are used, these sheets of the prepreg are stacked in the thickness direction and heated and pressurized.

In order to obtain a member in which no air is left, the prepreg may be pressurized and depressurized multiple times while being heated to a temperature equal to or higher than the melting point of the PFA before pressure-molding.

The disclosure also relates to a member for a semiconductor cleaning apparatus (hereinafter, also referred to as a second member), including a carbon fiber having an average fiber length of 0.5 mm or greater and a tetrafluoroethylene/perfluoro(alkyl vinyl ether) copolymer

(PFA). The second member is resistant to thermal deformation and is less likely to cause metal release.

Also, the second member has excellent strength, excellent conductivity (charge elimination property), and excellent chemical resistance.

The second member contains PFA and a carbon fiber having an average fiber length of 0.5 mm or greater. Such a member is resistant to thermal deformation and has excellent strength and conductivity. The second member can also prevent or reduce the metal release caused by penetration of a cleaning chemical into the member.

The average fiber length is preferably 1 mm or greater, more preferably 2 mm or greater, still more preferably 5 mm or greater, particularly preferably 10 mm or greater.

The upper limit of the average fiber length may be, but not limited to, the maximum length of the member.

The average fiber length may be the average fiber length of the carbon monofilaments constituting the carbon fiber.

The average fiber length may be measured by the above-described method.

Here, a member containing a carbon fiber having an average fiber length within the above range is distinguished from a molded article containing a short carbon fiber, which can be molded by injection molding or the like.

Preferably, in the second member, the PFA permeates the carbon fiber. This can reduce the voids in the member. Thus, the thermal deformation of the member can be further prevented or reduced, and the metal release caused by penetration of the cleaning chemical into the member can be further prevented or reduced.

Other preferred embodiments of the carbon fiber in the second member include those similar to the preferred embodiments of the carbon fiber in the first member. An example of the PFA in the second member is that similar to the PFA in the first member. The preferred amount of the carbon fiber in the second member is also similar to that in the first member.

The second member can be produced, for example, as follows. At least one sheet of the prepreg prepared by thermally fusing the carbon fiber having an average fiber length of 0.5 mm or greater and the PFA with each other is molded by heat compression. The preferred embodiment of the prepreg, the method for manufacturing the prepreg, and the method for manufacturing a member using the prepreg are the same as those for the first member.

The first and second members after 24-hour immersion in 3.6% by mass hydrochloric acid each cause an Al release of preferably 1.47 $ng/cm^2$ or less, more preferably 1.00 $ng/cm^2$ or less, still more preferably 0.50 $ng/cm^2$ or less, further more preferably 0.30 $ng/cm^2$ or less, particularly preferably 0.20 $ng/cm^2$ or less.

The first and second members after 24-hour immersion in 3.6% by mass hydrochloric acid each cause a Ca release of preferably 14.7 $ng/cm^2$ or less, more preferably 10.0 $ng/cm^2$ or less, still more preferably 5.0 $ng/cm^2$ or less, further more preferably 1.0 $ng/cm^2$ or less, particularly preferably 0.5 $ng/cm^2$ or less.

For the following metals, the metal release caused by the first or second member after 24-hour immersion in 3.6% by mass hydrochloric acid is preferably within the respective ranges described below.

Na, K, Mn, Cu, Zn, Pb:
The release of each metal is preferably 1.47 $ng/cm^2$ or less, more preferably 1.20 $ng/cm^2$ or less, still more preferably 1.10 $ng/cm^2$ or less.
Cr:
The release of the metal is preferably 14.7 $ng/cm^2$ or less, more preferably 12.0 $ng/cm^2$ or less, still more preferably 11.0 $ng/cm^2$ or less.
Fe, Ni:
The release of each metal is preferably 14.7 $ng/cm^2$ or less, more preferably 10.0 $ng/cm^2$ or less, still more preferably 5.0 $ng/cm^2$ or less, particularly preferably 1.0 $ng/cm^2$ or less.

Preferably, the release of at least one of these metals is within the corresponding range described above. More preferably, the releases of all the metals are within the respective ranges described above.

The releases of the above metals caused by the first or second member after 168-hour immersion in 3.6% by mass hydrochloric acid are also preferably within the respective ranges described above.

In particular, the first and second members after 168-hour immersion in 3.6% by mass hydrochloric acid each cause an Al release of preferably 1.47 $ng/cm^2$ or less, more preferably 1.00 $ng/cm^2$ or less, still more preferably 0.50 $ng/cm^2$ or less, further more preferably 0.30 $ng/cm^2$ or less, particularly preferably 0.20 $ng/cm^2$ or less.

The first and second members after 168-hour immersion in 3.6% by mass hydrochloric acid each cause a Ca release of preferably 14.7 ng/cm$^2$ or less, more preferably 10.0 ng/cm$^2$ or less, still more preferably 5.0 ng/cm$^2$ or less, further more preferably 1.0 ng/cm$^2$ or less, particularly preferably 0.5 ng/cm$^2$ or less.

The metal release is a value determined by the following measuring method.

(Sample)

A sample having a size of 40 mm in X-axis, 50 mm in Y-axis, and 5 mm in Z-axis is cut from each member.

(Pre-cleaning of sample)

The sample was placed in a PFA vessel (PFAS200 available from AS ONE Corporation), 100 ml of a test solution (3.6% by mass hydrochloric acid) is poured therein, and the vessel is covered with a lid and allowed to stand for 96 hours. After 96 hours, the lid is opened, and the sample is taken out with PFA tweezers, washed in running ultrapure water (flow rate 10 ml/sec) for 10 seconds, and placed in a separately prepared PFA vessel. The test solution in the PFA vessel is discarded, and another 50 ml of the test solution is placed therein. The vessel is covered with the lid and shaken with hands, the lid is opened, and the test solution is discarded.

This operation is performed three times to clean the PFA vessel.

(24 hour- or 168 hour-immersion test)

The cleaned sample is placed in the cleaned PFA vessel with PFA tweezers, 100 ml of the test solution is poured therein, and the vessel is covered with the lid and allowed to stand for 24 hours or 168 hours. Thereafter, the lid of the PFA vessel is opened. A portion of the test solution after the test is introduced into a measuring container of ICP-MS (Agilent Technologies), and the metal release in the target solution is measured. With the obtained value, the metal release caused by the sample is calculated using the following equation.

$$\text{Metal release (ng/cm}^2\text{) caused by sample} = \text{Metal release (ng) in target solution} \times (100/(\text{Volume (ml) of target solution in ICP-MS}))/\text{Surface area (cm}^2\text{) of sample}$$

The pre-cleaning of the sample is performed in order to remove metal attached to the surface of the sample. The duration of the pre-cleaning of the sample may be 24 hours.

The first and second members each exhibit a thermal deformation of preferably 1.0% or lower, more preferably 0.5% or lower, still more preferably 0.3% or lower after 60-minute heating at 200°C.

The first and second members each exhibit a thermal deformation of preferably 1.0% or lower, more preferably 0.5% or lower, still more preferably 0.3% or lower after 60-minute heating at 220°C.

The first and second members each exhibit a thermal deformation of preferably 1.0% or lower, more preferably 0.5% or lower, still more preferably 0.3% or lower after 60-minute heating at 240°C.

The first and second members each exhibit a thermal deformation of preferably 1.0% or lower, more preferably 0.5% or lower, still more preferably 0.3% or lower after 60-minute heating at 260°C.

The thermal deformation is a value determined by the following measuring method.

Samples each having dimensions of 15 mm in X-axis, 10 mm in Y-axis, and 5 mm in Z-axis are prepared. The dimensions in X- and Y-axes are measured with a caliper (ABS digital caliper CD-S20C available from MITUTOYO), and the dimension in Z-axis is measured with a micrometer (coolant proof micrometer MDC-25MX available from MITUTOYO). After measuring the dimensions, the sample is placed in an electric furnace (high-temperature, constant-humidity chamber STPH-202M available from Espec Corp.) previously heated to 200°C, 220°C, 240°C, or 260°C. After 60 min, the sample is taken out and cooled to room temperature. The dimensions of the sample are measured with the same caliper and micrometer as described above. The thermal shrinkage in each of the X-axis, Y-axis, and Z-axis is calculated using the following equation. The maximum value of the absolute values thereof is taken as a thermal deformation of the sample.

$$\text{Thermal shrinkage (\%)} = 100 \times (\text{Initial dimension} - \text{Dimension after heating})/\text{Initial dimension}$$

The first and second members are each used for a semiconductor cleaning apparatus. The first and second members each may be a member constituting the semiconductor cleaning apparatus.

Metal release caused by members of the semiconductor cleaning apparatus may cause contamination of a semiconductor. The first and second members, which are less likely to cause metal release, are less likely to contaminate a semiconductor. In addition, pre-cleaning of the members before incorporating them into the semiconductor cleaning apparatus can prevent or reduce contamination by metal release caused by the members. The first and second members, which are less likely to cause metal release, can be pre-cleaned in a reduced time.

Many semiconductor cleaning chemicals are highly reactive, such as concentrated sulfuric acid and hydrogen peroxide, and some semiconductors need to be cleaned at high temperatures. The first and second members, which have excellent chemical resistance and thermal deformation resistance, are not affected by a cleaning chemical and have small dimensional changes even in a high temperature environment. Thus, the first and second members have excellent durability.

Further, in the semiconductor cleaning apparatus, the cleaning chemical may be charged while passing through the piping. If the static charge is not eliminated, electrical breakdown may occur in the semiconductor. The first and second members, which have excellent conductivity (charge elimination property), can prevent the electrical breakdown of the semiconductor caused by the charged cleaning chemical.

The first and second members can be suitably used as members that are to be brought into contact with a semiconductor cleaning chemical. In particular, the first and second members are to be preferably brought into contact with at least one selected from the group consisting of sulfuric acid, hydrogen peroxide, hydrofluoric acid, hydrochloric acid, nitric acid, and phosphoric acid, more preferably with at least one selected from the group consisting of sulfuric acid, hydrogen peroxide, hydrofluoric acid, hydrochloric acid, and nitric acid.

The cleaning chemical may be liquid.

Preferably, the first and second members are also used as members that are to be brought into contact with a cleaning chemical.

The first and second members may also be used as members that are not to be brought into contact with a cleaning chemical.

The first and second members can also be suitably used as members that are to be brought into contact with a high temperature cleaning chemical. In particular, the first and second members are to be preferably brought into contact with a cleaning chemical having a temperature of 50°C or higher, more preferably brought into contact with a cleaning chemical having a temperature of 70°C or higher, still more preferably brought into contact with a cleaning chemical having a temperature of 100°C or higher, particularly preferably brought into contact with a cleaning chemical having a temperature of 130°C or higher, and preferably brought into contact with a cleaning chemical having a temperature of 260°C or lower, and more preferably brought into contact with a cleaning chemical having a temperature of 230°C or lower.

Preferably, the first and second members are also used as members that are to be brought into contact with a high-temperature cleaning chemical.

The first and second members may also be used as members that are not to be brought into contact with high-temperature cleaning chemicals.

The semiconductor cleaning apparatus to which the first or second member is to be applied may be either a batch cleaning apparatus or a single-wafer cleaning apparatus, preferably a single-wafer cleaning apparatus.

Examples of a method of bringing the semiconductor into contact with a cleaning chemical include a dipping method, a spinning method, and a spraying method. A spinning method is preferred.

The semiconductor cleaning apparatus is preferably a single-wafer spin cleaning apparatus.

The first and second members each can be suitably used as a turntable that rotates the semiconductor wafer and a member that supports the semiconductor wafer in the single-wafer spin cleaning apparatus.

An example of the member that supports the semiconductor wafer is a projection provided on the turntable and supporting the semiconductor wafer. The projection is preferably a chuck pin.

Fig. 1 is a view schematically showing an example of a semiconductor cleaning apparatus to which the members of the disclosure are applicable.

A semiconductor cleaning apparatus (single-wafer spin type cleaning apparatus) 10 includes a turntable 12 having a rotation mechanism 11.

Pins (chuck pins) 13 that support a semiconductor wafer 100 are provided on the turntable 12.

A cleaning chemical is jetted from a nozzle 14 provided in the semiconductor cleaning apparatus 10 while the semiconductor wafer 100 is rotated by rotating the turntable 12 with the rotation mechanism 11. Thereby, the semiconductor wafer 100 can be cleaned.

The semiconductor cleaning apparatus to which the members of the disclosure are applicable is not limited to those described above.

In a suitable embodiment, the members of the disclosure are each used in contact with a semiconductor cleaning chemical when the semiconductor is cleaned.

In another suitable embodiment, the semiconductor wafer is cleaned by a method including cleaning the semiconductor wafer supported by either one of the members of the disclosure with a chemical, with the member being in contact with the chemical.

EXAMPLES

The disclosure will be specifically described below referring to, but are not limited to, examples.

Example 1

<Preparation of prepreg>

Prepreg was prepared in accordance with the method disclosed in JP 2017-31342 A using the following materials under the following conditions.
Carbon fiber (T700SC-12000-60E available from Toray Industries, Inc.)
PFA film (Neoflon PFA AF-0050 available from Daikin Industries, Ltd.)

Conveyor belt: thermosetting polyimide resin film (UPILEX S available from Ube Industries, Ltd.)
Temperature of surface of heating roller: 360°C
Weight per unit area of opened carbon fiber: 18 g/m$^2$

<Preparation of chopped materials>

The prepreg was cut into chopped materials each having a width of 5 mm in the fiber direction and a length of 20 mm in the direction perpendicular to the fiber direction in accordance with the method disclosed in JP 2016-27956 A.

<Preparation of laminate>

The chopped materials were placed randomly in a mold and combined at a temperature of 360°C and a pressure of 5 MPa, followed by cooling to 60°C under pressure. The resulting workpiece was taken out from the mold. Thus, a laminate having a size of 300 mm × 300 mm × 5 mmt and containing 26% by mass (29% by volume) of a carbon fiber was prepared.

<Preparation of sample>

A sample having a size required for each of the measurements was cut from the laminate by a waterjet cutting machine (ProtoMax available from OMAX).

<Measurement of metal release>

(Test solution)

A test solution (3.6% by mass hydrochloric acid) was prepared by diluting 30% by mass concentrated hydrochloric acid (ultrapure grade reagent available from Kanto Chemical Co., Inc.) with ultrapure water.

(Sample)

A sample having a size of 40 mm in X-axis, 50 mm in Y-axis, and 5 mm in Z-axis was cut from the laminate.

(Pre-cleaning of sample)

The sample was placed in a PFA vessel (PFAS200 available from AS ONE Corporation), 100 ml of the test solution was poured therein, and the vessel was covered with a lid and allowed to stand for 96 hours. After 96 hours, the lid was opened, and the sample was taken out with PFA tweezers, washed in running ultrapure water (flow rate 10 ml/sec) for 10 seconds, and placed in a separately prepared PFA vessel. The test solution in the PFA vessel was discarded, and another 50 ml of the test solution was placed therein. The vessel was covered with the lid and shaken with hands, the lid was opened, and the test solution was discarded. This operation was performed three times to clean the PFA vessel.

(24 hour- or 168 hour-immersion test)

The cleaned sample was placed in the cleaned PFA vessel with PFA tweezers, 100 ml of the test solution was poured therein, and the vessel was covered with the lid and allowed to stand for 24 hours or 168 hours. Thereafter, the lid of the PFA vessel was opened. A portion of the test solution after the test was introduced into a measuring container of ICP-MS (Agilent Technologies), and the metal release in the target solution was measured. With the obtained value, the metal release caused by the sample was calculated using the following equation.

$$\text{Metal release } (ng/cm^2) \text{ caused by sample} = \text{Metal release} \ (ng) \text{ in target solution} \times (100/(\text{Volume } (ml) \text{ of target} \ \text{solution in ICP-MS}))/\text{Surface area } (cm^2) \text{ of sample}$$

The results are shown in Table 1.

Separately, a metal release after a 24 hour- or 168 hour-immersion test was measured as in the method described above except that the duration of the pre-cleaning of the sample was changed to 24 hours. The results are shown in Table 2.

<Measurement of thermal shrinkage>

Samples each having dimensions of 15 mm in X-axis, 10 mm in Y-axis, and 5 mm in Z-axis were prepared. The dimensions in X- and Y-axes were measured with a caliper (ABS digital caliper CD-S20C available from MITUTOYO), and the dimension in Z-axis was measured with a micrometer (coolant proof micrometer MDC-25MX available from MITUTOYO). After measuring the dimensions, the sample was placed in an electric furnace (high-temperature, constant-humidity chamber STPH-202M available from Espec Corp.) previously heated to 200°C, 220°C, 240°C, or 260°C. After 60 min, the sample was taken out and cooled to room temperature. The dimensions of the sample were measured with the same caliper and micrometer as described above. The thermal shrinkage in each of the X-axis, Y-axis, and Z-axis was calculated using the following equation.

$$\text{Thermal shrinkage } (\%) = 100 \times (\text{Initial dimension} - \ \text{Dimension after heating})/\text{Initial dimension}$$

The results are shown in Table 3.

<Evaluation of conductivity>

A specimen having a size of 100 mm in X-axis, 100 mm in Y-axis, and 5 mm in Z-axis was cut from the laminate, and subjected to measurement of the resistance with an insulation resistance tester (Megohm HiTester 3454-10 available from Hioki E.E. Corporation) at a voltage of 50 V, 125 V, 250 V, or 500 V. The results show that the resistance values in the X-, Y-, and Z-axes were 0.000 MΩ at all the voltages, indicating that the laminate had good conductivity.

[Table 1]

| Element | Release (ng/cm$^2$) | |
|---|---|---|
| | 24 hr | 168 hr |
| Li | <0.02 | <0.02 |
| Na | 0.04 | 0.04 |
| Mg | <0.02 | 0.06 |
| Al | 0.16 | 0.18 |
| K | 0.04 | <0.02 |
| Ca | <0.02 | <0.02 |

(continued)

| Element | Release (ng/cm$^2$) | |
|---|---|---|
| | 24 hr | 168 hr |
| Ti | <1.02 | <1.02 |
| Cr | <10.20 | <10.20 |
| Mn | <0.02 | <0.02 |
| Fe | <0.20 | 0.6120 |
| Co | <0.02 | <0.02 |
| Ni | 0.041 | 0.082 |
| Cu | <1.02 | <1.02 |
| Zn | <0.10 | <0.10 |
| Ag | <0.02 | <0.02 |
| Cd | <0.02 | <0.02 |
| Pb | <0.10 | <0.10 |

[Table 2]

| Element | Release (ng/cm$^2$) | |
|---|---|---|
| | 24 hr | 168 hr |
| Li | <0.02 | <0.02 |
| Na | 0.61 | 0.81 |
| Mg | 0.10 | 0.16 |
| Al | 0.20 | 0.81 |
| K | 0.40 | 0.81 |
| Ca | 0.61 | 1.02 |
| Ti | <1.02 | <1.02 |
| Cr | <10.20 | <10.20 |
| Mn | 0.06 | 0.04 |
| Fe | 3.47 | 3.67 |
| Co | <0.02 | <0.02 |
| Ni | 0.24 | 0.06 |
| Cu | <1.02 | <1.02 |
| Zn | 0.39 | 0.47 |
| Ag | <0.02 | <0.02 |
| Cd | <0.02 | <0.02 |
| Pb | <0.10 | <0.10 |

[Table 3]

| Treatment temperature (°C) | | 200 | 220 | 240 | 260 |
|---|---|---|---|---|---|
| Shrinkage (%) | X-axis direction | -0.1 | 0.0 | 0.1 | 0.0 |
| | Y-axis direction | 0.0 | 0.0 | 0.1 | 0.2 |
| | Z-axis direction | 0.1 | 0.2 | 0.2 | 0.2 |

Comparative Example 1

Using only the PFA film, a molded sheet consisting of PFA having dimensions of 300 mm × 300 mm × 5 mm was obtained by the same molding method as that for preparing the laminate. A sample having a size of 100 mm in X-axis, 100 mm in Y-axis, and 5 mm in Z-axis was cut from the molded sheet consisting of PFA, and subjected to measurement of the resistance with an insulation resistance meter (Megohm HiTester 3454-10 available from Hioki E.E. Corporation) at a voltage of 50 V, 125 V, 250 V, or 500 V. The results demonstrate that the resistance values in the X-axis, Y-axis, and Z-axis showed overflow values (infinite) at all voltages, indicating that the molded sheet consisting of PFA was unsuitable as a member for a semiconductor cleaning apparatus.

REFERENCE SIGNS LIST

10:     semiconductor cleaning apparatus
11:     rotating mechanism
12:     turntable
13:     pin
14:     nozzle
100:   semiconductor wafer

**Claims**

1.   A member for a semiconductor cleaning apparatus, comprising prepreg containing a carbon fiber and a tetrafluoroethylene/perfluoro(alkyl vinyl ether) copolymer which are thermally fused with each other.

2.   The member for a semiconductor cleaning apparatus according to claim 1,
     wherein two or more sheets of the prepreg are stacked and combined by heat compression.

3.   The member for a semiconductor cleaning apparatus according to claim 1 or 2,
     wherein the prepreg includes a thermally fused article of a sheet of the carbon fiber and a film of the tetrafluoroethylene/perfluoro(alkyl vinyl ether) copolymer.

4.   A member for a semiconductor cleaning apparatus, comprising a carbon fiber having an average fiber length of 0.5 mm or greater and a tetrafluoroethylene/perfluoro(alkyl vinyl ether) copolymer.

5.   The member for a semiconductor cleaning apparatus according to any one of claims 1 to 4,
     wherein the carbon fiber represents 5 to 70% by volume of a total amount of the carbon fiber and the tetrafluoroethylene/perfluoro(alkyl vinyl ether) copolymer.

6.   The member for a semiconductor cleaning apparatus according to any one of claims 1 to 5,
     wherein the carbon fiber is opened.

7.   The member for a semiconductor cleaning apparatus according to any one of claims 1 to 6,
     wherein the member is to be brought into contact with at least one selected from the group consisting of sulfuric acid, hydrogen peroxide, hydrofluoric acid, hydrochloric acid, nitric acid, and phosphoric acid.

8.   The member for a semiconductor cleaning apparatus according to any one of claims 1 to 7,

wherein the member is to be brought into contact with a cleaning chemical at a temperature of 100°C or higher.

9. The member for a semiconductor cleaning apparatus according to any one of claims 1 to 8,
wherein the member causes an Al release of 1.47 ng/cm$^2$ or less after 24-hour immersion in 3.6% by mass hydrochloric acid.

10. The member for a semiconductor cleaning apparatus according to any one of claims 1 to 9,
wherein the member causes an Al release of 1.47 ng/cm$^2$ or less after 168-hour immersion in 3.6% by mass hydrochloric acid.

11. The member for a semiconductor cleaning apparatus according to any one of claims 1 to 10,
wherein the member causes a Ca release of 14.7 ng/cm$^2$ or less after 24-hour immersion in 3.6% by mass hydrochloric acid.

12. The member for a semiconductor cleaning apparatus according to any one of claims 1 to 11,
wherein the member causes a Ca release of 14.7 ng/cm$^2$ or less after 168-hour immersion in 3.6% by mass hydrochloric acid.

13. The member for a semiconductor cleaning apparatus according to any one of claims 1 to 12,
wherein the member exhibits a thermal deformation of 1.0% or lower after 60-minute heating at 220°C.

14. The member for a semiconductor cleaning apparatus according to any one of claims 1 to 13,
wherein the member exhibits a thermal deformation of 1.0% or lower after 60-minute heating at 260°C.

FIG.1

## INTERNATIONAL SEARCH REPORT

International application No.

PCT/JP2020/037733

### A. CLASSIFICATION OF SUBJECT MATTER

H01L 21/304(2006.01)i; B29C 70/06(2006.01)i
FI: H01L21/304 643A; H01L21/304 648K; B29C70/06; H01L21/304 646

According to International Patent Classification (IPC) or to both national classification and IPC

### B. FIELDS SEARCHED

Minimum documentation searched (classification system followed by classification symbols)
H01L21/304-21/308; B08B3/00-3/14; B08B13/00; B29C70/06-24; C08J5/04-10

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X <br> Y | JP 2010-260922 A (NIPPON VALQUA INDUSTRIES, LTD.) 18 November 2010 (2010-11-18) paragraphs [0011]-[0054] | 1, 4-5, 8 <br> 1-14 |
| X <br><br> Y | JP 2019-151111 A (SAN FURORO SYST KK) 12 September 2019 (2019-09-12) paragraphs [0036]-[0142] | 1, 4-5, 7-8, 13-14 <br> 1-14 |
| X <br> Y | JP 2012-532217 A (E. I. DU PONT DE NEMOURS AND COMPANY) 13 December 2012 (2012-12-13) claims, paragraphs [0011]-[0073], fig. 1A-2C | 1, 4-5, 8 <br> 1-14 |
| X <br> Y | WO 2019/155975 A1 (TOHO KASEI CO., LTD.) 15 August 2019 (2019-08-15) paragraphs [0016]-[0071] | 1, 7-12 <br> 1-14 |
| Y | JP 2014-113713 A (MITSUBISHI RAYON CO., LTD.) 26 June 2014 (2014-06-26) paragraphs [0008]-[0038] | 1-3, 5-14 |

☒ Further documents are listed in the continuation of Box C. ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 December 2020 (14.12.2020) | 28 December 2020 (28.12.2020) |

| Name and mailing address of the ISA/ <br> Japan Patent Office <br> 3-4-3, Kasumigaseki, Chiyoda-ku, <br> Tokyo 100-8915, Japan | Authorized officer <br><br> Telephone No. |
|---|---|

Form PCT/ISA/210 (second sheet) (January 2015)

**INTERNATIONAL SEARCH REPORT**

| International application No. |
| --- |
| PCT/JP2020/037733 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | WO 2007/020910 A1 (TEIJIN TECHNO PRODUCTS LTD.) 22 February 2007 (2007-02-22) paragraphs [0010]-[0015] | 1-3, 5-14 |

Form PCT/ISA/210 (continuation of second sheet) (January 2015)

<table>
<tr><th colspan="2">INTERNATIONAL SEARCH REPORT<br>Information on patent family members</th><th>International application No.<br>PCT/JP2020/037733</th><th></th></tr>
<tr><td>Patent Documents<br>referred in the<br>Report</td><td>Publication<br>Date</td><td>Patent Family</td><td>Publication<br>Date</td></tr>
<tr><td>JP 2010-260922 A</td><td>18 Nov. 2010</td><td>WO 2010/125989 A1<br>TW 201041910 A</td><td></td></tr>
<tr><td>JP 2019-151111 A</td><td>12 Sep. 2019</td><td>WO 2018/101423 A1<br>EP 3549885 A1<br>paragraphs [0014]-<br>[0117]<br>TW 201840691 A<br>CN 110035960 A<br>KR 10-2019-0091276 A</td><td></td></tr>
<tr><td>JP 2012-532217 A</td><td>13 Dec. 2012</td><td>WO 2011/002867 A1<br>column 3, line 26 to<br>column 18, line 17,<br>claims, fig. 1A-2C<br>US 2011/0001082 A1<br>CN 102471501 A<br>KR 10-2012-0106712 A</td><td></td></tr>
<tr><td>WO 2019/155975 A1</td><td>15 Aug. 2019</td><td>TW 201936657 A</td><td></td></tr>
<tr><td>JP 2014-113713 A</td><td>26 Jun. 2014</td><td>(Family: none)</td><td></td></tr>
<tr><td>WO 2007/020910 A1</td><td>22 Feb. 2007</td><td>US 2009/0104418 A1<br>paragraphs [0010]-<br>[0015]<br>EP 1927618 A1<br>CN 101243121 A<br>KR 10-2008-0033315 A</td><td></td></tr>
</table>

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001358109 A
- JP 3064019 B
- JP 3146200 B
- JP 2016027956 A
- JP 2017031342 A